# EUROPEAN PATENT SPECIFICATION

(11) **EP 3 175 686 B1**
(45) Date of publication and mention of the grant of the patent: **20.02.2019**
(21) Application number: 15753621.0
(22) Date of filing: 30.07.2015
(51) Int. Cl.: H05K 7/14

(54) **LOCKING DEVICE FOR RACKABLE ELECTRONIC EQUIPMENT**
ARRETIERUNGSVORRICHTUNG FÜR RACKFÄHIGE ELEKTRONISCHE AUSRÜSTUNG
DISPOSITIF DE VERROUILLAGE POUR ÉQUIPEMENT ÉLECTRONIQUE APTE À ÊTRE MONTÉ SUR BÂTI

(30) Priority: 31.07.2014 FR 1457414
(43) Date of publication of application: 07.06.2017
(73) Proprietor: Connecteurs Electriques Deutsch, 27000 Evreux (FR)
(72) Inventor: MOREAU, Jean-Luc, 28200 Chateaudun (FR)
(74) Representative: Grünecker Patent- und Rechtsanwälte PartG mbB
(86) International application number: PCT/EP2015/067563
(87) International publication number: WO 2016/016392

(56) References cited:
- EP-A1- 2 257 145
- US-A- 5 268 821
- "SINGLE-LEVER PRINTED CIRCUIT CARD INSERTER/EXTRACTOR", IBM TECHNICAL DISCLOSURE BULLETIN, INTERNATIONAL BUSINESS MACHINES CORP. (THORNWOOD), US, vol. 32, no. 4B, September 1989 (1989-09), pages 204-209, XP000067013, ISSN: 0018-8689

## Description

The present invention relates to a locking and unlocking device for a rackable piece of electronic equipment such as a rackable electronic board.

Pieces of equipment and in particular removable electronic boards able to be connected to a rack backplane connector are known in the state of the art. In the aviation field, given the strong vibrations experienced by the onboard electronic apparatus, in systems for locking rackable electronic boards, it is known to provide locking of the board to a rack backplane by a central screw system with prevention of unlocking by vibration. Such a system proves effective for the maintenance of locking but is expensive and slow to operate. Another integrated locking system is also known, with inserters, but proves limited in locking and unlocking power when the number of contacts to be connected becomes large.

Moreover, equipment manufacturers, and particularly aircraft manufacturers, are constantly looking for savings in terms of costs, mass, reliability, assembly time on mounting and maintenance time of the different pieces of equipment. However, given that the electronic racks integrate more and more boards including in their turn an increasing number of contacts to be connected, the insertion and extraction forces of the boards are becoming larger and larger. Increasingly powerful and strong locking systems are therefore necessary, like the integrated connection system known from patent EP 2 257 145 B1, which discloses a hinged lever integrated at the back of a rackable electronic board and cooperating with locking strips of the board which allow hooking onto the backplane of the rack and, under the action of the lever, traction of the board so as to cause it to advance in the rack and to lock the assembly. However, such locking systems, although increasingly powerful and strong, are also increasingly heavy and costly.

An aim of the present invention is therefore to provide a solution to the above-mentioned problems and therefore to provide a quick, light and more economical connection system than the known systems, while providing at least as effective locking as the known systems.

The aim is attained by a locking device for a rackable piece of electronic equipment, the device comprising a first mounting element and a second mounting element essentially forming a hinged lever able to cooperate with at least one locking organ of a rackable piece of electronic equipment so as to lock said rackable piece of electronic equipment with a rack backplane. According to the present invention, the locking device is removable and the locking device further comprises a spring arranged in a first longitudinal direction and a first end of which is linked to the first mounting element and a second end of which is linked to a hinged end movable in translation of the second mounting element.

Thus, instead of an integrated locking system which increases the weight and the cost of the rackable pieces of electronic equipment, the present invention provides a removable tool able to be reused for locking or unlocking in succession a plurality of rackable electronic equipment to a rack backplane. The device according to the invention can advantageously be left mounted on the back of a rackable piece of electronic equipment once this has been locked to a rack, or detached in order to be reused to lock or unlock other rackable pieces of electronic equipment. A same device according to the invention can therefore advantageously be used for the locking or unlocking of a plurality of rackable pieces of electronic equipment.

A locking and unlocking tool according to the invention thus has an advantage of cost and mass in particular for rack systems accommodating a plurality of rackable pieces of electronic equipment. Indeed, the known rack systems of the state of the art must make compatible the additional weight of each integrated locking system in each of the rackable pieces of electronic equipment locked in the rack, as well as their respective cost. Thus, by means of the present invention, the more rackable pieces of electronic equipment accommodated in the rack, the greater is the saving in weight and apparatus cost relative to the known integrated systems of the state of the art. This therefore presents a considerable advantage for equipment manufacturers and in particular for aircraft manufacturers.

Moreover, the use of a removable tool permits manual connection or disconnection of rackable electronic boards equipped with several tens of contacts with reasonable force relative to the known systems, in particular those using inserters. Thus, in an embodiment of the present invention, the locking device can be used to lock at least one rackable electronic board in a rack backplane. In this case, after insertion of the board into the slideway of the rack, the locking device according to the present invention is mounted on the back of the board, and then actuated to provide, in cooperation with at least one locking organ of the board, locking of the board in the rack backplane. As required, the device according to the invention can then be left in place on the back of the board, or unmounted to lock or unlock other boards.

Preferably, the first mounting element can extend in a first longitudinal direction and comprise a first end comprising at least one, in particular two, mounting members able to
cooperate with a respective locking organ of a rackable piece of electronic equipment. In an advantageous embodiment, the first end can thus be terminated by a first mounting member, in particular U-shaped. The device can then be mounted on the back of a rackable piece of electronic equipment so as to cooperate with a peg or a spindle of the rackable piece of electronic equipment, in particular of a movable locking organ of the rackable piece of electronic equipment, and thus form a locking lever. Moreover, in a preferred modified embodiment, the first mounting element can comprise in addition, in the direction of its first end, a second mounting member projecting essentially perpendicularly to the first longitudinal direction, and forming in particular a hook extending in the direction of said first end. Thus the device can be mounted so as to form a locking lever bearing on more than one, for example two points, for example two pegs or spindles, of the rackable piece of electronic equipment, one of which can be movable and the other fixed.

Preferably, the second mounting element can be an element permitting transmission of movement, extending in a second longitudinal direction, and a first end of which is hinged relative to the first mounting element. Thus, in an embodiment of the present invention, the second mounting element can be a rod or a similar piece hinged about a spindle passing through the first mounting element.

Moreover, the hinged end of the second mounting element can advantageously in addition be movable in translation in the first longitudinal direction, in particular by sliding along a groove formed in the first mounting element. Thus, it is possible to provide transmission of the lever movement of the locking device so as to cause the other end of the second mounting element to cooperate with other locking organs of the rackable piece of electronic equipment.

In an advantageous embodiment, a rod cooperating with a spring also linked to the first mounting element can therefore provide sensorial locking by return of the locking tool if the locking is not effective.

Advantageously, the second mounting element can comprise a second end comprising at least one, in particular two, mounting member(s) able to cooperate with a respective locking organ of a rackable piece of electronic equipment. Thus in similar manner to the first mounting element, the second mounting element can also cooperate with at least one peg or spindle mounted at the back of the rackable piece of electronic equipment, in particular of one or more movable locking organs of the equipment. In a preferred embodiment, the second mounting element can therefore also comprise in addition, in the direction of the second end, a second mounting member projecting in essentially perpendicular manner to the second longitudinal direction, and forming in particular a hook extending in the direction of said second end. It is therefore possible to advantageously cause the locking device to cooperate with a plurality of fixed or movable locking organs, so as to cause a rackable piece of electronic equipment to advance in a rack and to lock it with the rack backplane.

In an advantageous modification, the second mounting element can comprise in addition, in the direction of the second end, a locking member retracting into the second mounting element, and forming in particular a hook moving away from the second end. It is therefore possible to cause the locking member to cooperate with a fixed peg or spindle in the device in order to maintain the locking.

Preferably, the locking device can comprise in addition a handle of longitudinal shape in which said first and second mounting elements are partially arranged. The device can therefore have a housing or a case in which the mounting elements are arranged and can therefore form a removable handle for rackable electronic equipment.

In this case, the first mounting element can preferably be arranged in the handle in the first longitudinal direction and fixed relative to this, in particular so that the first mounting member of the first mounting element is projecting relative to the handle, in particular relative to an end of the handle, in the first longitudinal direction. In a preferred embodiment, the locking and unlocking tool can therefore form a removable handle, in which are mounted, on the one hand, the first mounting element in fixed manner, and on the other, the second mounting element in pivoting and/or sliding manner.

Advantageously, the handle can comprise in addition at least one visual indicator of a state of locking and/or unlocking. Thus, the device according to the invention can also provide secure locking monitored by a visual indicator. According to preferred embodiments of this modification, a visual indicator can be for example a text or a coloured strip indicating the locking state.

Preferably, the handle can comprise in addition a movable locking finger, in particular in translation, able to displace, in particular release, the second mounting element, in particular so as to facilitate unmounting of the locking device from a rackable piece of electronic equipment. Thus, depending on the position of the locking finger, it is possible to provide the maintenance or the unhooking of the locking device from a rackable piece of electronic equipment. According to the embodiment, the device according to the invention can therefore form a handle removable by actuation of a locking finger.

In this case, it can be advantageous for the displacement to be performed by means of a spring cooperating with the locking finger. According to preferred modifications, the spring can be the same spring as that which can be used to return the second mounting element. In other modifications, it can also be a second spring which can also be arranged in the first longitudinal direction and cooperate on the one hand with the locking finger, and on the other with the second mounting element so as to push this back from a locked position towards an unlocked position permitting unmounting of the locking device from a rackable piece of electronic equipment.

Moreover, said at least one visual indicator can then be visible depending on a position of the locking finger. Thus, it is possible to combine the position of the locking finger with the visual indication of the locking state.

Finally, the aim is also attained by an assembly comprising at least one rackable electronic board equipped with a locking device according to the present invention and its modifications. According to the embodiments, the aim is also attained by an assembly of a plurality of rackable electronic boards inserted in a rack, in a locked state or otherwise, in which at least one of the rackable electronic boards is equipped with a locking device according to the present invention.

Thus, a single locking device, otherwise called a single removable tool, advantageously permits locking and unlocking of all the rackable pieces of electronic equipment of a same rack, or more generally all the pieces of electronic equipment of a same type of rack. Consequently, in the case of multiple racks, the invention is the more advantageous as it permits the use of only a single tool for assembly of all the rackable pieces of electronic equipment of the different levels of a multiple rack. The mechanism for connection of the rackable electronic boards can therefore be simplified relative to the known boards of the state of the art integrating a locking system. The rackable electronic boards being able to be mounted by means of the locking device according to the invention can therefore allow the saving of weight, of cost, and increased simplicity relative to the rackable electronic boards known in the state of the art. In other words, the invention also allows lesser wear of the locking system and therefore increased reliability relative to the known systems. Moreover, in case of a problem with the locking, the invention allows changing of only the tool instead of having to change a whole electronic board, which would be the case for the known boards of the state of the art which integrate the locking system in non-removable manner.

The present invention will be explained in more detail in the following description of advantageous embodiments based on the following accompanying figures, in which:
- figure 1 is a perspective view of an example of the locking device according to an embodiment of the present invention;
- figure 2 is a perspective view of a locking step of a rackable piece of electronic equipment inserted in a rack, and of the locking device of figure 1;
- figure 3 is a perspective view of another locking step of the rackable piece of electronic equipment of figure 2, showing the mounting of the locking device of figure 1;
- figure 4 is a detail of another locking step of the rackable piece of electronic equipment of figures 2 and 3, and of the locking device of figure 1, showing a locked state;
- figure 5 is a view illustrating a locked state, but in a broader perspective than the detail of figure 4; and
- figure 6 is a perspective view showing the use of the locking device of figure 1 to lock one or more rackable pieces of electronic equipment in a multiple rack.

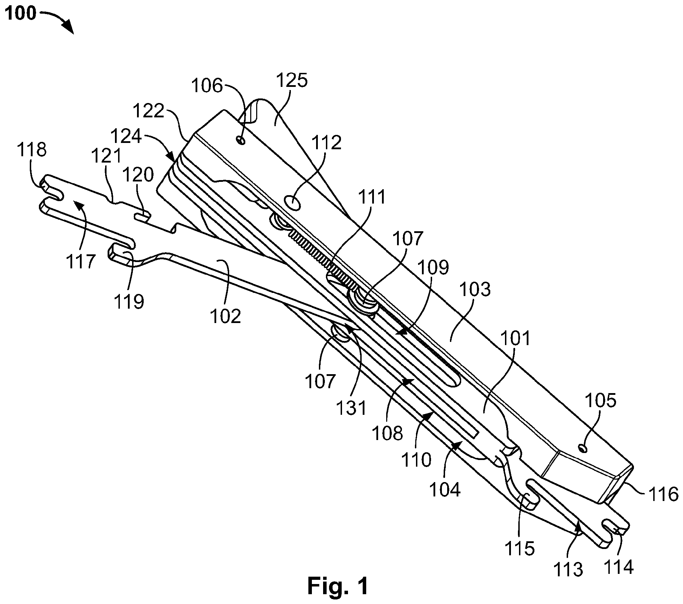

Figure 1 is a perspective view of a locking tool 100 showing an example of an embodiment of a locking device according to the invention. According to the invention, the tool 100 is a removable tool allowing the locking and unlocking of a rackable piece of electronic equipment to a rack backplane. Contrarily to the locking systems integrated in the rackable electronic boards of the state of the art, the tool 100 is removable and can therefore be used for locking and unlocking of a plurality of rackable pieces of electronic equipment, which therefore allows saving of size and weight relative to integrated systems, but also in terms of production cost of the electronic boards given that these are simplified.

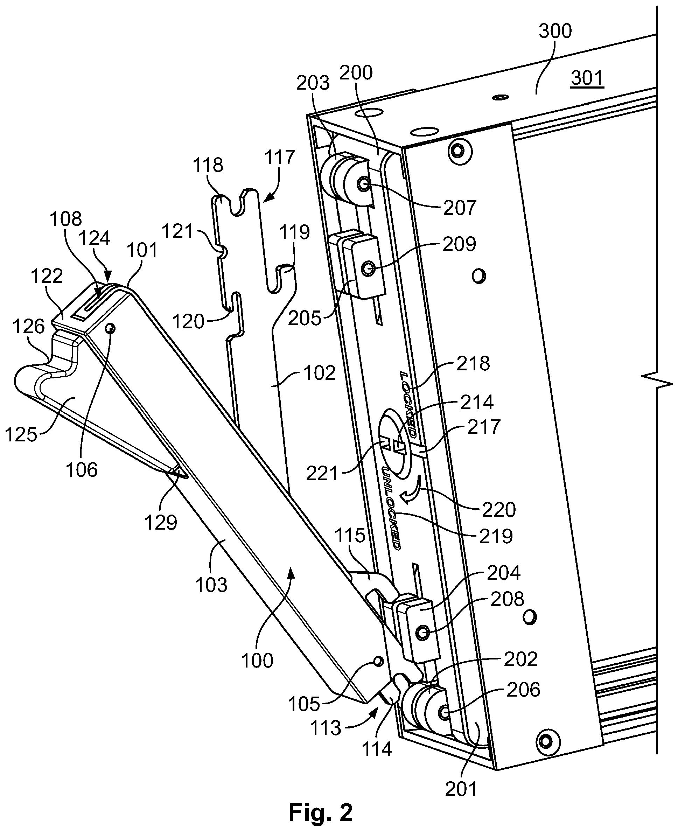

As shown in figure 1, a locking tool 100 according to the present invention therefore comprises a first mounting element 101 and a second mounting element 102, which is hinged relative to the first element 101, in particular in pivoting manner. Thus, the tool 100 essentially forms a hinged lever when it is mounted on the back of a rackable electronic board, as in the embodiment shown in the following figures 2 to 6.

According to preferred and advantageous modifications of the invention, figure 1 shows that the tool 100 can comprise an elongate handle part 103 which can be a housing comprising a groove 104 in which can be accommodated, and preferably fixed, the first mounting element 101. The handle 103 can therefore comprises at least one transversal spindle providing the fixing of the first mounting element 101. In the embodiment shown in figure 1, the handle 103 thus comprises at least two spindles 105, 106 passing through the first mounting element 101 in transversal manner.

Moreover, the two mounting elements 101, 102 can be of elongate form, for example strips, the first mounting element 101 and the handle 103 then extending in the same direction, which therefore defines a first relative longitudinal direction of the tool 100. The direction in which the second mounting element 102 extends can then define a second relative longitudinal direction of the tool 100, forming a variable angle with the first longitudinal direction, depending on the relative position of the two mounting elements 101, 102.

Figure 1 also shows that, according to preferred modified embodiments, the second element 102 can be a strip of rod type of which one end 131 is passed through by a spindle 107, also passing through the first mounting element 101, thus forming the hinge, in other words the pivot, between the two mounting elements 101, 102. Moreover, according to another advantageous modified embodiment, the hinged strip 102, or rather the end 131, can be movable in translation relative to the first mounting element 101, in particular by sliding in a groove 108 formed in the longitudinal direction of the first mounting element 101. Similarly, the spindle 107 can pass through the groove 108 from one side to the other and slide in the lateral grooves 109, 110 also formed in the first mounting element 101, so that the end 131 can slide along grooves 108, 109, 110, thus forming a slideway.

According to another preferred modified embodiment, figure 1 shows that in addition to pivoting relative to the first mounting element 101, on the translation movement in the groove 108, the second mounting element 102 can also be returned by a spring 111, one end of which can be fixed to a peg or spindle 112 of the first element 101 and of the handle 103 and the other end can be fixed to the projecting part of the spindle 107 relative to the groove 109.

Figure 1 also shows that, according to other advantageous modified embodiments, an end 113 of the first mounting element 101 can be terminated by a U-shaped member 114. As also shown in figure 1, the member 114 can be projecting in the first longitudinal direction as an extension of an end 116 of the handle 103, in other words as an extension of the element 101 in its longitudinal direction. The element 101 can also comprise, in the direction of the end 113, another mounting member 115, this time projecting in essentially perpendicular manner to the first longitudinal direction, and forming a hook extending in the direction of the end 113.

In similar manner, the free end 117 of the second mounting element 102 can be extended in the second longitudinal direction by a mounting member 118, which can also be U-shaped, and a second mounting member 119 can be made in similar manner to the member 115 of the first element 101, i.e. in a hook projecting in perpendicular manner to the strip 102 and extending in the direction of the end 117.

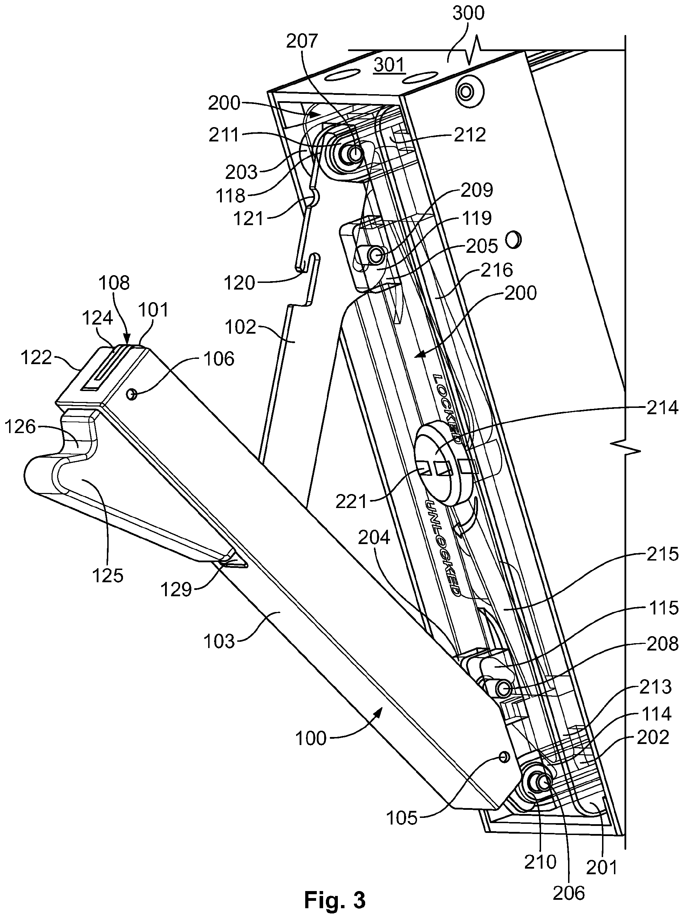

As shown below by the detailed examples with reference to figures 2 and 3, the mounting members 114, 118 at the respective ends 113, 117 of the mounting elements 101, 102 are able to cooperate with a respective locking organ of a rackable piece of electronic equipment. In particular, the members 114, 118 can cooperate with a spindle of a respective movable locking organ provided at the back of the rackable pieces of equipment. The hooks 115, 119 are also able to cooperate with a locking organ of the rackable piece of equipment, in particular with a spindle of a fixed locking organ provided at the back of the rackable pieces of electronic equipment.

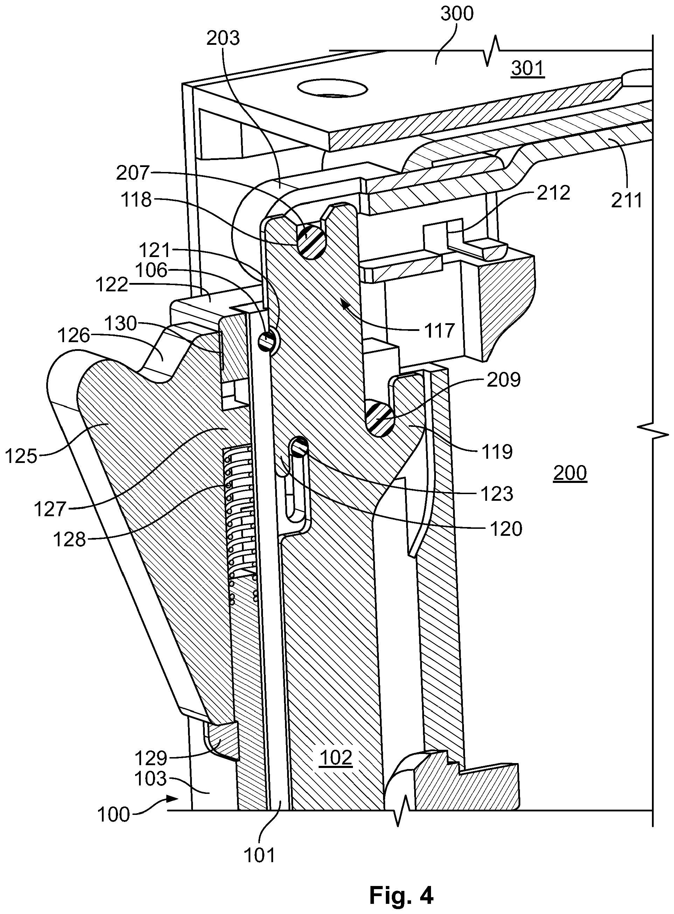

According to another still advantageous modified embodiment, figure 1 shows in addition that opposite to the projecting mounting member 119 can be situated a locking member 120 retracting into the strip 102 or forming a cavity in the strip 102 giving the member 120 a hook shape extending in an opposite direction to that of the hook 119. As shown more closely in figure 4, the hook 120 can catch onto a spindle 123 inside the tool 100 so as to maintain the locking.

Figure 1 also shows that the second then 122 the handle 103, as well as the second end 124 of the first element 101, can be open so as to allow retraction of the second element 102 when this pivots towards the locked position, as in figure 4. In this case, just above the hook 120, in the direction of the end 117 of the mounting element 102, can be situated a notch 121 allowing the mounting element 102 to be received in the groove 108, in the locked position of the system, without being hampered by the spindle 106.

According to yet another modified embodiment, the tool 100 can also comprise a locking finger 125, visible in figure 1, mounted in movable manner on the handle 103, in particular in sliding manner, and the action of which will be better understood by means of figure 4.

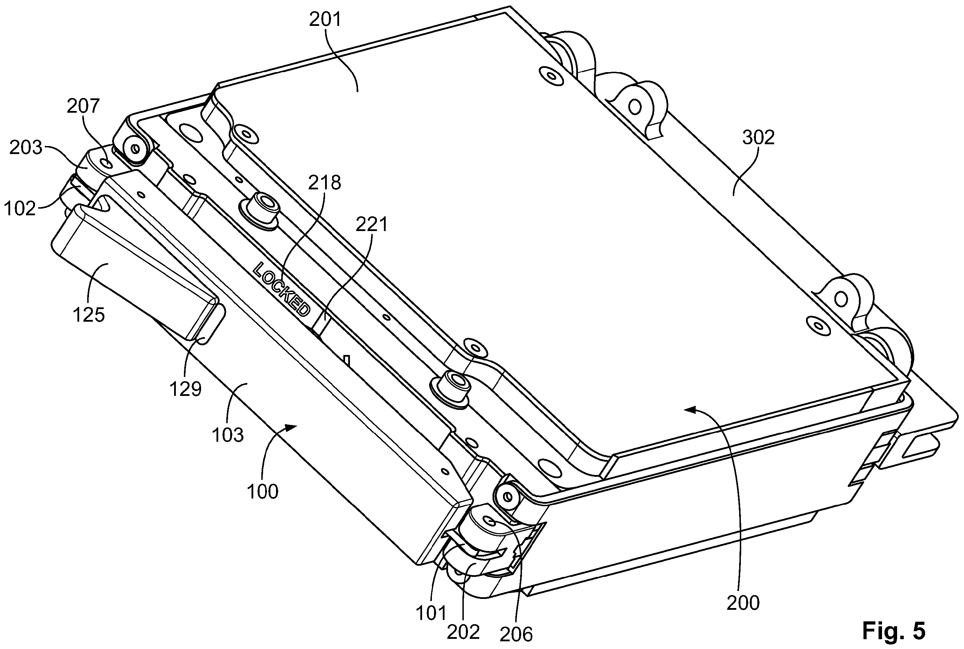

Figure 2 is a partial perspective view of a rackable electronic board 200 inserted in a rack 300, also showing the locking tool 100 of the embodiment shown in figure 1 before mounting on the back of the board 200. In this step, the electronic board 200 is inserted in the case 301 of the rack 300 but is not yet locked with the rack backplane 302 (not shown in figure 2, but visible in figure 5). The insertion can be effected manually by causing the board 200 to slide in a slideway (not shown) of the rack 300. The part not shown of the board 200, or "front" part of the board 200, can include a plurality of electrical contacts intended to be plugged into the backplane 302 of the rack 300, which can therefore include counterpart electrical contacts. The part of the electronic board 200 visible in figure 2 can therefore also be called the "back" part of the board 200.

Like certain known electronic boards of the state of the art, the board 200 of the embodiment shown in figure 2 and in the following figures, comprises integrated locking organs permitting locking to the backplane of the rack 300. However, contrarily to the known integrated locking systems of the state of the art, the electronic board 200 of the embodiment shown in figure 2 does not include an integrated locking lever, locking being performed by mounting and actuation of the removable locking tool 100 of the embodiment shown in figure 1, which, once the board 200 is locked in the rack 300, can be unmounted from the back of the board 200 and reused to lock or unlock other boards. Consequently, the electronic board 200 is lighter and less costly to manufacture than the known electronic boards of the state of the art with an integrated locking system.

Figure 2 shows in addition that the electronic board 200 can include at least one movable locking organ and a least one corresponding fixed locking organ, permitting locking of it to the backplane of the rack 300 by lever effect of the tool 100. Advantageously, in the embodiment shown in figure 2 and in the following figures, the electronic board 200 thus includes pairs of locking organs, one mobile and the other fixed relative to the case 201 of the board 200, able to cooperate with the pairs of mounting organs 114, 115 or 118, 119 of the locking tool 100. Thus, the board 200 includes the first movable 202 and fixed 204 locking organs, on the one hand, and the second movable 203 and fixed 205 locking organs, on the other. As shown in figures 2 et seq., the movable locking organs 202 and 203 can cooperate with the mounting organs 114 and 118 at the respective ends 113, 117 of the mounting elements 101, 102 of the tool 100. Similarly, the fixed locking organs 204 and 205 can cooperate with the hooks 115 and 119 of the locking tool 100, thus creating the desired lever effect.

Figure 2 shows a possible strategy for mounting the tool 100 at the back of the electronic board 200. In this embodiment, the arrangement of the pairs of locking organs 202, 204 and 203, 205 can be symmetrical, so that the mounting of the tool 100 can be performed either according to the example shown, or in symmetrical manner. In other words, the pair of mounting organs 113, 114 can be mounted in cooperation with the pair of locking organs 202, 204, the pair of mounting organs 118, 119 then cooperating with the pair of locking organs 203, 205, as shown in figures 2 et seq. However, in other embodiments, if the pair of mounting organs 113, 114 is mounted in cooperation on the pair of locking organs 203, 205, the pair of mounting organs 118, 119 will then have to be mounted respectively on the locking organs 202, 204 (reversed position not illustrated of the tool 100).

Figure 3 shows the locking tool 100 in position on the back of the board 200, the case 201 of which has been made transparent in order to show the locking organs of the board 200. The U-shaped mounting organ 114 is positioned on a spindle 206 of the movable locking organ 202, the latter comprising in addition a locking strip 210 one end of which can be wound round the spindle 206, the other part (not shown) being used for locking on the backplane of the rack 300. A spindle 208 of the fixed locking organ 204 can then be hooked by the associated hook 115 of the first mounting element 101. Similarly, the pivoting mounting element 102 can form an angle with the fixed mounting element 101 of the tool 100, which permits, also under the action of the spring 111, positioning of the other U-shaped mounting organ 118 against a spindle 208 of the other movable locking organ 203, and also hooking of a spindle 209 of the other fixed locking organ 205 by means of the hook 119. Like the other movable locking organ 202, the locking organ 203 can also include a locking strip 211 an end of which can be wound around the spindle 207 and the other part of which is also used for locking on the backplane of the rack 300.

A lever movement folding the tool 100 in the direction of the board 200 can then allow traction of the board 200 and locking of it to the backplane of the rack 300 by means of the locking strips 210, 211. By lever effect of the hooks 114, 119 about the spindles 208, 209 of the fixed locking organs 204, 205, the cooperation of the U-shaped mounting organs 114, 118 and of the movable locking organs 202, 203 can therefore allow the locking strips 210, 211 to make the board 200 advance to its locking position in the backplane of the rack 300, as shown in particular in figures 4 to 6. Thus, when the locking tool 100 is actuated and mounted in its locking position, the second mounting element 102 is pivoted flat in the groove 108, as shown in the sectional view of figure 4, so that the hook 120 hooks the spindle 123, the notch 121 surrounds the spindle 106, and the free end 117 of the second mounting element 102 is projecting from the end 122 of the handle 103 in similar manner to the end 113 of the first mounting element 101 relative to the other end 116 of the handle 103. The spring 111 can be stretched and cause the mounting members 118, 119 to respectively apply a pressure on the spindles 207, 209.

With reference in particular to figure 3, the electronic board 200 can also comprise a self-locking or secondary locking system ensuring the maintenance of the locking of the board 200 in the rack 300 in order to unmount the tool 100 for reuse with other rackable pieces of electronic equipment. The board 200 can therefore comprise a locking button 214 cooperating with two secondary locking strips 215, 216 which, as soon as the movable locking organs 202, 203 advance under the action of the tool 100, can be stopped in respective secondary locking stops 212, 213 of the organs 202, 203. The stops 212, 213 can be seen transparently by way of example in figure 3, the stop 212 being shown moreover in more detail in figure 4. In this manner, once the strips 210, 211 of the locking organs 202, 203 are in the locking position in the backplane of the rack 300, the secondary locking strips 215, 216 ensure the maintenance of the locked position of the main locking strips 210, 211 in the backplane of the rack 302 and then allow the tool 100 to be unmounted without risk of disconnection.

The unmounting of the tool 100 can then be performed by actuation of the end 126 of the locking finger 125, thus causing the descent of the locking finger 125, which can finally release the spindle 123 from the hook 120, and thus cause the second mounting element 102 to slide or pivot in the groove 108 and about the spindle 107 so as to disengage the mounting members 118, 119 from the spindles 207, 209. For this purpose, according to a preferred modified embodiment, the locking finger 125 can comprise in addition a lug 127 which, on the actuation of the finger 125, can compress a spring 128, visible in figure 4, able to be linked to the second mounting element 102 of the tool 100. Once the members 118, 119 are disengaged, the tool 100 can be simply unmounted from the board 200 and reused to lock or unlock other rackable pieces of electronic equipment, while leaving the board 200 locked in the rack 300 by means of the secondary locking strips 215, 216, which are visible in figure 3 but have been concealed in figure 4 to show the detail of the stop 212 of the movable locking organ 203.

Figure 5 shows the electronic board 200 locked to the rack backplane 302, with the case 301 of the rack 300 concealed, and with the locking tool 100 mounted in the locked position. The locking position or state can be indicated in a plurality of manners, in particular by means of visual indicators such as texts, coloured strips, combinations of these or other similar means.

For example figures 2 to 5 show visual indicators 129, 130 of the locking state on the handle 103 of the locking tool 100. In particular, these indicators 129, 130 can be placed on the handle 103, at the ends of the locking finger 125, so that in the locked state, when the locking finger 125 is in its upper position as shown, an indicator 129 corresponding to the locked state can be visible below the locking finger 125. Conversely, if the locking finger 125 is actuated, figure 4 allows another indicator 130 to be seen, which will be visible in the lower position of the finger 125, therefore corresponding to an unlocked state allowing the tool 100 to be unmounted from the back of a rackable piece of electronic equipment.

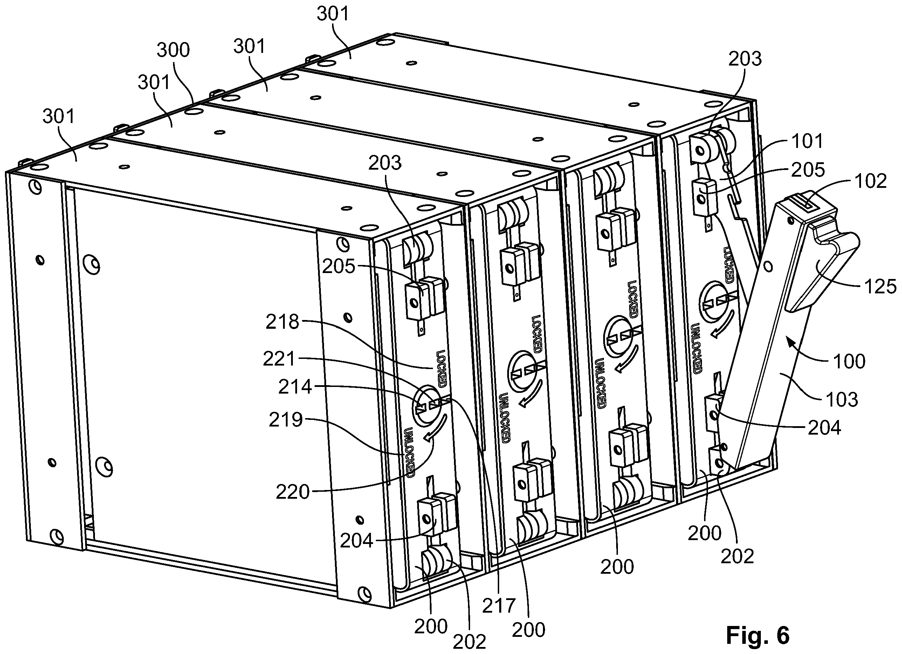

Similarly, a rackable piece of electronic equipment compatible with the locking tool 100 can itself also comprise an indicator of a locking state. Thus, as shown in figures 2, 3, 5 and 6, the case 201 of the electronic board 200 can comprise visual indicators 217, 218, 219 at least one of which can correspond with a visual indicator 221 of the locking button 214 in a locked or unlocked state of the board 200. For example, in the example embodiments shown in figures 2 to 6, figures 2 and 3 show an unlocked state of the board 200, in which the indicator 221 of the button 214 is turned towards the unlocked state indicator 219 of the case 201, while figure 6 shows a locked state of each board 200 in the multiple rack 300, with the indicator 221 of the button 214 turned towards the locked state indicators 217, 218 of the case 201.

In the embodiments shown, each of the U-shaped mounting members 114, 118 at the ends of the mounting elements 101, 102 can in addition subsequently act as screwdrivers in order to unscrew the locking button 214, for example in a direction which can be indicated by a visual indicator 220 on the case 201 of the electronic board 200, so as to disengage the secondary locking strips 215, 216 from the stops 212, 213. The board 200 can then be unlocked from the rack 300 by mounting the tool 100 at the back of this board, as in figure 3, and by pulling on the tool 100 instead of levering towards the board 200.

Figure 6 finally shows an example in which the rack 300 is a multiple rack able to accommodate a plurality of electronic boards 200. The locking tool 100 according to the present invention can therefore be used in advantageous manner for locking or unlocking of each electronic board 200 of the multiple rack 300. In particular, a single tool 100 can be used for all the locking or unlocking operations of all the boards 200 of the multiple rack 300. The tool 100 can be left, as required, mounted at the back of one of the boards 200 in its locked state, as in figures 4 and 5, or it can be detached to make the assembly more compact and lighter. Whichever the case, the multiple rack 300 filled with electronic boards 200 compatible with the locking tool 100 will be more compact and lighter than if it were equipped with known electronic boards of the state of the art with an integrated lever connection system, which can present a considerable advantage in the case in which the multiple rack 300 would be used for the aeronautic industry or any application having limitations to the onboard load. Each rackable electronic board 200 will not only be lighter, but also cheaper than a known rackable electronic board of the state of the art integrating the whole connection system, while retaining all the advantages of reliability and locking. Moreover, in the case of problems with the locking tool 100, this alone will have to be replaced to continue the operations on a whole set of electronic boards 200, which presents another advantage relative to the replacement of a whole electronic board with an integrated connection system such as those known of the state of the art.

As is apparent from the preceding description, the present invention is not limited to the locking of rackable electronic boards in the aviation field, but can be adapted to any type of rackable pieces of electronic equipment used in other fields. However, in the particular field of Aeronautics, in which the weight of the onboard systems plays a leading role, and in associated fields, the invention presents a considerable advantage relative to the known state of the art, given that a single tool is necessary to lock a set of electronic boards to a rack system, which allows reduction of the weight of each board, and therefore of the whole of the rack and of the onboard electronics, relative to known systems of the state of the art in which the board comprises an integrated locking lever. Moreover, the invention presents an advantage relative to the known systems of the state of the art, in particular when the connection and disconnection forces become too great for manual locking mechanisms of inserter type, or for a saving of time relative to a coupling screw system.

### REFERENCE SIGNS

- 100: locking tool
- 101: first mounting element
- 102: second mounting element, rod
- 103: handle
- 104: groove
- 105: spindle
- 106: spindle
- 107: spindle
- 108: groove
- 109: lateral groove
- 110: lateral groove
- 111: spring
- 112: spindle
- 113: end of the first mounting element
- 114: mounting member
- 115: mounting member, hook
- 116: end of the handle
- 117: free end of the second mounting element
- 118: mounting member
- 119: mounting member, hook
- 120: locking member, hook
- 121: notch
- 122: end of the handle
- 123: spindle
- 124: end of the first mounting element
- 125: locking finger
- 126: end of the locking finger
- 127: lug
- 128: spring
- 129: marking of the locked state
- 130: marking of the unlocked state
- 131: end of the second mounting element
- 200: rackable electronic board
- 201: electronic board case
- 202: movable locking organ
- 203: movable locking organ
- 204: fixed locking organ
- 205: fixed locking organ
- 206: spindle
- 207: spindle
- 208: spindle
- 209: spindle
- 210: locking strip
- 211: locking strip
- 212: secondary locking stop
- 213: secondary locking stop
- 214: locking button
- 215: secondary locking strip
- 216: secondary locking strip
- 217: locked state indicator
- 218: locked state indicator
- 219: unlocked state indicator
- 220: unlocking direction
- 221: locked state indicator
- 300: rack
- 301: rack case
- 302: back plane of rack

## Claims

1. Locking device (100) of a rackable piece of electronic equipment, the device comprising:
a first mounting element (101) and a second mounting element (102) essentially forming a hinged lever able to cooperate with at least one locking organ of a rackable piece of electronic equipment so as to lock said rackable piece of electronic equipment with a rack backplane,
**characterised in that**
the locking device (100) is removable and **in that** the locking device further comprises a spring (111) arranged in a first longitudinal direction and a first end of which is linked to the first mounting element (101) and a second end of which is linked to a hinged end movable in translation (131) of the second mounting element (102).

2. Locking device (100) according to claim 1, in which the first mounting element (101) extends in a first longitudinal direction and comprises a first end (113) comprising at least one, preferably two, mounting member(s) (114, 115) able to cooperate with a respective locking organ of a rackable piece of electronic equipment.

3. Locking device (100) according to any one of the preceding claims, in which the second mounting element (102) extends in a second longitudinal direction and comprises a first end (131) hinged relative to the first mounting element (101).

4. Locking device (100) according to claim 3, in which the hinged end (131) of the second mounting element (102) is in addition movable in translation along the first longitudinal direction, in particular by sliding along at least one groove (108) formed in the first mounting element (101).

5. Locking device (100) according to claim 3 or 4, in which the second mounting element (102) comprises a second end (117) comprising at least one, preferably two, mounting member(s) (118, 119) able to cooperate with a respective locking organ of a rackable piece of electronic equipment.

6. Locking device (100) according to claim 5, in which the second mounting element (102) comprises in addition, in the direction of its second end (117), a locking member (120) retracting into the second mounting element (102), and forming in particular a hook departing from said second end (117).

7. Locking device (100) according to any one of the preceding claims, comprising in addition a handle (103) of longitudinal form in which are partially arranged said first and second mounting elements (101, 102).

8. Locking device (100) according to claim 7, in which the first mounting element (101) is arranged in the handle (103) in a first longitudinal direction and is fixed relative to this, in particular, in combination with claim 2, so that said at least one mounting member (114, 115) of the first mounting element (101) is projecting relative to the handle (103), in particular relative to an end (116) of the handle (103).

9. Locking device (100) according to any one of claims 7 or 8, in which the handle (103) comprises in addition a visual indicator (129, 130) of a locking and/or unlocking state.

10. Locking device (100) according to any one of claims 7 to 9, in which the handle (103) comprises in addition a locking finger (125) movable, in particular in translation, able to displace, in particular release, the second mounting element (102), in particular so as to facilitate the unmounting of the locking device (100) from a rackable piece of electronic equipment (200).

11. Locking device (100) according to claim 10 in combination with claim 9, in which said at least one visual indicator (129, 130) is visible depending on a position of the locking finger (125).

12. Assembly including at least one rackable electronic board (200) equipped with a locking device (100) according to one of the preceding claims.

## Patentansprüche

1. Arretiervorrichtung (100) eines rackfähigen (rackable) elektronischen Anlagenteils, wobei die Vorrichtung umfasst:
ein erstes Anbringungs-Element (101) und ein zweites Anbringungs-Element (102), die im Wesentlichen einen Gelenkhebel bilden, der mit wenigstens einem Arretierteil eines rackfähigen elektronischen Anlagenteils zusammenwirken kann, um das rackfähige elektronische Anlagenteil an einer Rack-Rückwand zu arretieren,
**dadurch gekennzeichnet, dass**
die Arretiervorrichtung (100) abnehmbar ist und die Arretiervorrichtung des Weiteren eine Feder (111) umfasst, die in einer ersten Längsrichtung angeordnet ist und deren erstes Ende mit dem ersten Anbringungselement (101) verbunden ist und deren zweites Ende mit einem schwenkbaren Ende verbunden ist, das bei Verschiebung (131) des zweiten Anbringungs-Elementes (102) bewegt werden kann.

2. Arretiervorrichtung (100) nach Anspruch 1, wobei sich das erste Anbringungs-Element (101) in einer ersten Längsrichtung erstreckt und ein erstes Ende (113) umfasst, das wenigstens ein, vorzugsweise zwei, Anbringungs-Teil/e (114, 115) umfasst, das/die mit einem entsprechenden Arretierteil eines rackfähigen elektronischen Anlagenteils zusammenwirken kann/können.

3. Arretiervorrichtung (100) nach einem der vorangehenden Ansprüche, wobei sich das zweite Anbringungs-Element (102) in einer zweiten Längsrichtung erstreckt und ein erstes Ende (131) umfasst, das relativ zu dem ersten Anbringungs-Element (101) schwenkbar gelagert ist.

4. Arretiervorrichtung (100) nach Anspruch 3, wobei das schwenkbar gelagerte Ende (131) des zweiten Anbringungs-Elementes (102) zusätzlich in der ersten Längsrichtung verschoben werden kann, insbesondere, indem es in wenigstens einer Nut (108) verschoben wird, die in dem ersten Anbringungs-Element (101) ausgebildet ist.

5. Arretiervorrichtung (100) nach Anspruch 3 oder 4, wobei das zweite Anbringungs-Element (102) ein zweites Ende (117) umfasst, das wenigstens ein, vorzugsweise zwei Anbringungs-Teil/e (118, 119) umfasst, das/die mit einem entsprechenden Arretierteil eines rackfähigen elektronischen Anlagenteils zusammenwirken kann/können.

6. Arretiervorrichtung (100) nach Anspruch 5, wobei das zweite Anbringungs-Element (102) zusätzlich in der Richtung seines zweiten Endes, (117) ein Arretierteil (120) umfasst, das in das zweite Anbringungs-Element (102) hinein zurückgesetzt ist und insbesondere einen Haken bildet, der von dem zweiten Ende (117) ausgeht.

7. Arretiervorrichtung (100) nach einem der vorangehenden Ansprüche, die zusätzlich einen Griff (103) in länglicher Form umfasst, in dem das erste und das zweite Anbringungs-Element (101, 102) teilweise angeordnet sind.

8. Arretiervorrichtung (100) nach Anspruch 7, wobei das erste Anbringungs-Element (101) in dem Griff (103) in einer ersten Längsrichtung angeordnet ist und relativ dazu fixiert ist, insbesondere in Kombination mit Anspruch 2, so dass das wenigstens eine Anbringungs-Teil (114, 115) des ersten Anbringungs-Elementes (101) relativ zu dem Griff (103), insbesondere relativ zu einem Ende (116) des Griffs (103), vorsteht.

9. Arretiervorrichtung (100) nach einem der Ansprüche 7 oder 8, wobei der Griff (103) zusätzlich eine Einrichtung (129, 130) zum visuellen Anzeigen eines Arretier- und/oder Entarretier-Zustandes umfasst.

10. Arretiervorrichtung (100) nach einem der Ansprüche 7 bis 9, wobei der Griff (103) zusätzlich einen Arretier-Finger (125), der bewegt, insbesondere verschoben, werden kann und in der Lage ist, das zweite Anbringungs-Element (102) zu verschieben, insbesondere zu lösen, um so insbesondere das Demontieren der Arretiervorrichtung (100) von einem rackfähigen elektronischen Anlagenteil zu ermöglichen.

11. Arretiervorrichtung (100) nach Anspruch 10 in Kombination mit Anspruch 9, wobei die wenigstens eine Einrichtung (129, 130) zum visuellen Anzeigen in Abhängigkeit von einer Position des Arretier-Fingers (125) sichtbar ist.

12. Baugruppe, die wenigstens eine rackfähige Elektronikplatine (200) enthält, die mit einer Arretiervorrichtung (100) nach einem der vorangehenden Ansprüche ausgestattet ist.

## Revendications

1. Dispositif de verrouillage (100) d'une pièce pouvant être montée dans un rack d'un équipement électronique, le dispositif comprenant :
un premier élément de montage (101) et un second élément de montage (102) formant essentiellement un levier articulé capable de coopérer avec au moins un organe de verrouillage d'une pièce pouvant être montée dans un rack d'un équipement électronique de manière à verrouiller ladite pièce pouvant être montée dans un rack d'un équipement électronique avec une face arrière de rack,
**caractérisé en ce que**
le dispositif de verrouillage (100) est amovible et **en ce que** le dispositif de verrouillage comprend en outre un ressort (111) disposé dans une première direction longitudinale et dont une première extrémité est reliée au premier élément de montage (101) et dont une seconde extrémité est reliée à une extrémité articulée mobile en translation (131) du second élément de montage (102).

2. Dispositif de verrouillage (100) selon la revendication 1, dans lequel le premier élément de montage (101) s'étend dans une première direction longitudinale et comprend une première extrémité (113) comprenant au moins un, de préférence deux, membre(s) de montage (114, 115) capable(s) de coopérer avec un organe de verrouillage respectif d'une pièce pouvant être montée dans un rack d'un équipement électronique.

3. Dispositif de verrouillage (100) selon l'une quelconque des revendications précédentes, dans lequel le second élément de montage (102) s'étend dans une seconde direction longitudinale et comprend une première extrémité (131) articulée par rapport au premier élément de montage (101).

4. Dispositif de verrouillage (100) selon la revendication 3, dans lequel l'extrémité articulée (131) du second élément de montage (102) est de plus mobile en translation le long de la première direction longitudinale, en particulier par coulissement le long d'au moins une gorge (108) formée dans le premier élément de montage (101).

5. Dispositif de verrouillage (100) selon la revendication 3 ou 4, dans lequel le second élément de montage (102) comprend une seconde extrémité (117) comprenant au moins un, de préférence deux, membre(s) de montage (118, 119) capable(s) de coopérer avec un organe de verrouillage respectif d'une pièce pouvant être montée dans un rack d'un équipement électronique.

6. Dispositif de verrouillage (100) selon la revendication 5, dans lequel le second élément de montage (102) comprend de plus, dans la direction de sa seconde extrémité (117), un membre de verrouillage (120) se rétractant dans le second élément de montage (102), et formant en particulier un crochet sortant de ladite seconde extrémité (117).

7. Dispositif de verrouillage (100) selon l'une quelconque des revendications précédentes, comprenant de plus une poignée (103) de forme longitudinale dans laquelle sont disposés partiellement lesdits premier et second éléments de montage (101, 102).

8. Dispositif de verrouillage (100) selon la revendication 7, dans lequel le premier élément de montage (101) est disposé dans la poignée (103) dans une première direction longitudinale et est fixé par rapport à celle-ci, en particulier, en combinaison avec la revendication 2, de sorte que ledit au moins un membre de montage (114, 115) du premier élément de montage (101) fait en saillie par rapport à la poignée (103), en particulier par rapport à une extrémité (116) de la poignée (103).

9. Dispositif de verrouillage (100) selon l'une quelconque des revendications 7 ou 8, dans lequel la poignée (103) comprend de plus un indicateur visuel (129, 130) d'un état de verrouillage et/ou de déverrouillage.

10. Dispositif de verrouillage (100) selon l'une quelconque des revendications 7 à 9, dans lequel la poignée (103) comprend de plus un doigt de verrouillage (125) mobile, notamment en translation, capable de déplacer, en particulier de libérer, le second élément de montage (102), en particulier pour faciliter le démontage du dispositif de verrouillage (100) à partir d'une pièce pouvant être montée dans un rack d'un équipement électronique (200).

11. Dispositif de verrouillage (100) selon la revendication 10 en combinaison avec la revendication 9, dans lequel ledit au moins un indicateur visuel (129, 130) est visible en fonction d'une position du doigt de verrouillage (125).

12. Ensemble comprenant au moins une carte électronique pouvant être montée dans un rack (200) équipée d'un dispositif de verrouillage (100) selon l'une des revendications précédentes.
